# EUROPEAN PATENT APPLICATION

(11) **EP 1 746 655 A2**
(43) Date of publication of application: **24.01.2007**
(21) Application number: 06253647.9
(22) Date of filing: 12.07.2006
(51) Int. Cl.: H01L 27/146

(54) **An optimized image sensor process and structure to improve blooming**

(30) Priority: 22.07.2005 US 701725 P; 24.08.2005 US 210996
(71) Applicant: OmniVision Technologies, Inc., Sunnyvale, California 94089 (US)
(72) Inventor: Rhodes, Howard E., Boise, Idaho 83706 (US); Nozaki, Hidetoshi, Santa Clara, California 95050 (US); Manabe, Sohei, San Jose, California 95129 (US); Tai, Hsin-Chih, Sunnyvale, California 94089 (US); Nagaraja, Satyadev H., San Jose, California 95128 (US); Shah, Ashish A., Sunnyvale, California 94086 (US); Qian, William, Sunnyvale, California 94087 (US); Yang, Hongli, Cupertino, California 95014 (US); Dai, Tiejun, Sunnyvale, California 94086 (US)
(74) Representative: Hackney, Nigel John

(57) **Abstract**

An image sensor that has a pixel array using an isolation structure between pixels that reduce electrical cross-talk is disclosed. The pixel array is formed on a substrate that has a thin (less than 5 microns) epitaxial layer. The isolation structure uses a deep p-well to surround a shallow trench isolation. The deep p-well is formed using an implant energy of typically over 700 keV.

## Description

### CROSS-REFERENCE TO RELATED APPLICATION

This application claims the benefit of U.S. Provisional Application No. 60/701,725, filed July 22, 2005, which is incorporated herein by reference.

Blooming is a bright light image artifact that affects both CCD and CMOS Image sensors. In a scene with a bright region, such as a reflection from a chrome bumper on a car, blooming can occur in the captured image. As the scene is imaged onto an array of pixels (such as on a CMOS or CCD image sensor), some of the pixels in the sensor receive the light from the bright region. The incident light is much more intense on those pixels than the other pixels of the imager that capture other aspects of the scene. For the pixels that image the bright region of the scene, the charge created by the photosensitive element (e.g. photodiode, pinned photodiode, or photogate) is much more than can be stored in these individual pixels. If the charge created by the exposure diffuses to adjacent pixels, then the image of the bright region appears larger in the image than it is in the actual scene. This apparent growth of a bright spot due to "blooming" is an issue with current CCD and CMOS image sensors.

There are two primary causes for blooming: optical and electrical. Optical blooming is a result of light scatter, reflection, and/or diffraction. In each of these cases light that is directed initially at a particular target pixel is actually received by an adjacent pixel due to the physical mechanisms of scattering, reflection, and/or diffraction. Electrical blooming refers to the diffusion of the charge (electron signal) from the target pixel to an adjacent pixel. When light (a photon) is received by a pixel, an electron-hole pair is created. Ideally the electron is stored in the target pixel photosensitive element. However, if that electron diffuses to an adjacent pixel, the result is blooming.

Optical blooming can be improved by reducing the stack height of the image sensor so that the photosensitive element is closer to its micro-lens. Optical blooming can also be improved by using light shields to prevent photons from being scattered into adjacent pixels.

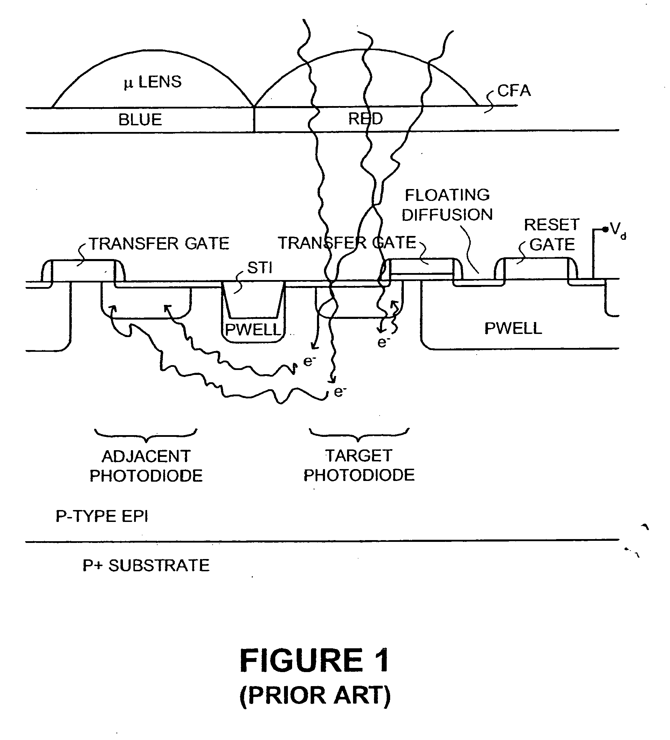

For color image sensors, at low light levels, blooming also results in color cross-talk. Because of electron diffusion, not all electrons are stored in the target pixel. Some of the electrons created in the target pixel diffuse to an adjacent pixel even under non-saturating (bright) light conditions. For color image sensors, there is a mosaic of red, green, and blue pixels as a result of the red, green, and blue color filters that are placed over each pixel. See Figure 1. Electrons generated under a red pixel that diffuse to an adjacent blue pixel are interpreted as a blue signal rather than a red signal. This results in color crosstalk and an unwanted change in the true color of the scene.

To illustrate further, Figure 1 shows a prior art four transistor (4T) pixel for a CMOS image sensor. There are shown two adjacent photosensitive elements: (1) the target photosensitive element under the red color filter array (CFA) and (2) the adjacent photosensitive element under the blue CFA. There is a shallow trench isolation (STI) and standard shallow P-well isolation between these two photosensitive elements. Also shown is a transfer gate, a reset gate, a floating diffusion, and a Vdd drain. For simplicity the source follower and row select transistors are not shown. These structures are formed on a P+ substrate over which there is a p-type epi layer. The STI isolation between pixels is typically 2000-5000 angstroms (A), usually about 3000 A deep. The P-well isolation between pixels is typically about 4500 A deep which can be achieved with about a 160 keV B11 implant. The epi thickness is typically about 8 microns thick. Thus, it is clear that Figure 1 is not drawn to scale.

In Figure 1, three incident light photons are shown schematically impinging on the target pixel. All three light photons penetrate the red color filter and so the light is red light and this light penetrates fairly deep into the silicon under the target photosensitive element. This results in the creation of 3 electrons in the silicon below the target photosensitive element. One of these electrons is collected by the target photosensitive element. However, the other two electrons are shown diffusing to the adjacent pixel where they are collected by the adjacent photosensitive element. This adjacent photosensitive element is under the blue color filter and the stored charge in this photosensitive element will be interpreted as blue light. The electrons collected by the adjacent photosensitive element represent unwanted blooming and color cross-talk.

To improve electrical blooming performance, the prior art uses a lateral overflow drain (LOD) or a vertical overflow drain (VOD). Neither of these is satisfactory by themselves. In the lateral overflow drain, there is placed next to a photosensitive element a transistor or transistors that are connected to a positive voltage supply voltage, i.e., a current drain. During excessive light exposure, the electrons that overflow the capacity of the photosensitive element may result in a current through the adjacent transistors to the drain. In the vertical overflow drain, a doping profile is created vertically under the photosensitive element. When the electron level in a particular photosensitive element exceeds a VOD barrier potential, the electrons then flow over the barrier to the VOD drain. The formation of a VOD is a complicated process requiring additional masking and implants.

In its broadest, the present invention provides an improved process that does not add the process complexity of a VOD but improves the blooming and cross-talk issues that remain in a LOD structure. In a first aspect, the present invention provides a pixel array according to claim 1.

### BRIEF DESCRIPTION OF THE FIGURES

Figure 1 is a cross-section view of a portion of a prior art pixel array of an image sensor showing electrical cross-talk.
Figure 2 is a cross-section view of a portion of a pixel array of an image sensor in accordance with the present invention.
Figures 3 and 4 are graphs showing experimental results comparing blooming between a pixel array of the present invention and pixel arrays of the prior art.
Figures 5 and 6 are cross-section views of a semiconductor substrate showing one method of forming isolation structures used in the present invention.

### DETAILED DESCRIPTION

Various embodiments of the invention will now be described. The following description provides specific details for a thorough understanding and enabling description of these embodiments. One skilled in the art will understand, however, that the invention may be practiced without many of these details. Additionally, some well-known structures or functions may not be shown or described in detail, so as to avoid unnecessarily obscuring the relevant description of the various embodiments.

The terminology used in the description presented below is intended to be interpreted in its broadest reasonable manner, even though it is being used in conjunction with a detailed description of certain specific embodiments of the invention. Certain terms may even be emphasized below; however, any terminology intended to be interpreted in any restricted manner will be overtly and specifically defined as such in this Detailed Description section.

The description of the embodiments of the invention and their applications as set forth herein is illustrative and is not intended to limit the scope of the invention. Variations and modifications of the embodiments are possible and practical alternatives to, or equivalents of the various elements of, the embodiments disclosed herein and are known to those of ordinary skill in the art. Such variations and modifications of the disclosed embodiments may be made without departing from the scope and spirit of the invention.

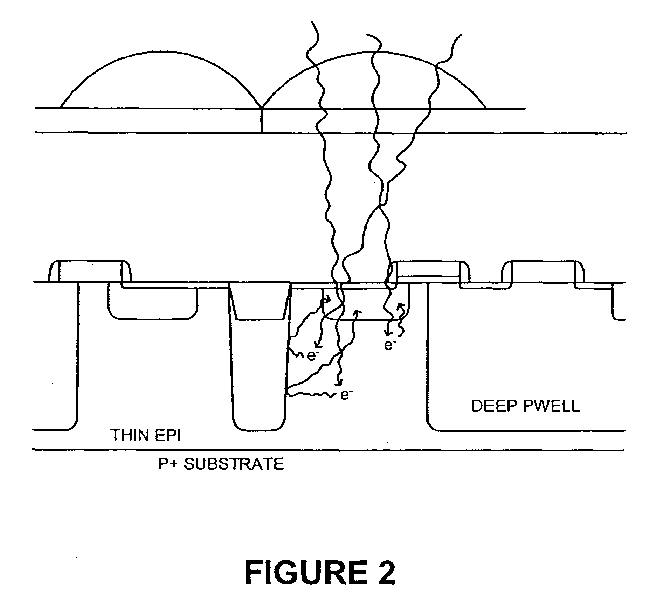

Figure 2 illustrates an embodiment of the present invention that significantly improves blooming and color cross-talk. The present invention is effective for all CMOS and CCD image sensors, including but not limited to 3T, 4T, and 5T CMOS image sensors and interline or frame transfer CCD image sensors. Figure 2 is similar to Figure 1, except that according to the present invention, Figure 2 shows a pixel array using isolation that is a combination of a thin epi of thickness 2-6 microns and a deep P-well (DPW) implant process with B I 1 implant energies of greater than or equal to 700 keV. As seen in Figure 2, again there is shown the creation of three electrons deep below the target photosensitive element. But in this case, the combination of the thin epitaxial layer and the deep P-well form electron reflective or absorptive regions that prevent these electrons from diffusing to the adjacent pixel.

Thus, by using a thin epi layer (less than 6 microns), the p+ substrate is "brought into play" and is used as an electron barrier to prevent electron migration. In the prior art, because of the combination of shallow p-well around the STI and a thick epi layer, electrons were able to migrate under the isolation structures into adjacent pixels. Additionally, by using a high energy implant for the p-well, a deeper p-well may be formed for the isolation structure, thereby further impeding electron migration. In this embodiment, the STI is the same as in the prior art, but it is to be understood that the STI may also be modified to be deeper.

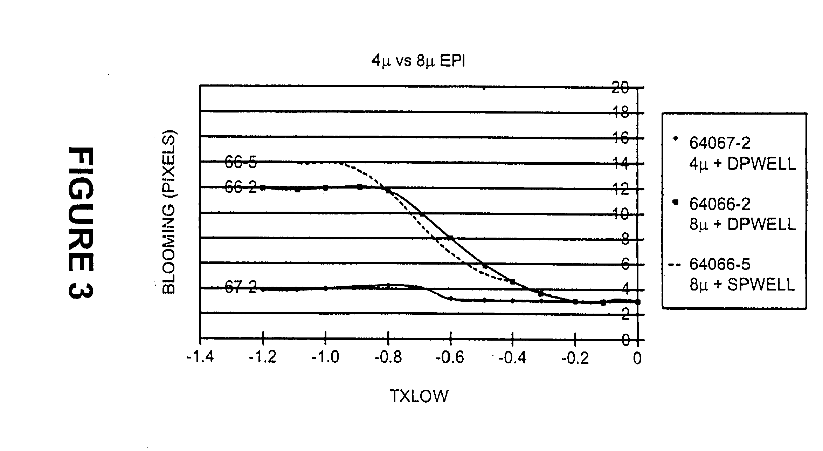

Figure 3 shows experimental data that verifies the significance of having both a DPW and a thin epi. In the experiment, a bright image is focused on one half of an array of pixels. Under low light conditions a sharp demarcation is recorded between the bright and dark region. When the light intensity is increased well beyond the pixel saturation level (e.g. 100X - 1000X saturation), the bright image blooms into the adjacent pixels. The lateral extent of the blooming is measured and recorded as the y-value in Figure 3. Thus, the higher the value on the y-axis, the greater the blooming.

Figure 3 shows the lateral extent of the blooming measured in 3.18 micron pixels as a function of the low voltage on the transfer gate (Vtx_lo) during integration. At very negative transfer gate voltages, the transfer gate is turned off, and the result is substantial blooming. At Vtx_lo voltages approaching 0 volts, the transfer gate is closer to being turned on during integration, and both the output signal (not shown) is reduced and the blooming is reduced.

It is important to achieve good blooming performance at negative Vtx_lo where the output signal is not degraded. The conventional prior art approach with an 8 micron epi layer and a shallow P-well (sample 64066-5 in Figure 3) results in substantial blooming at very negative transfer gate voltages. In contrast, the use of a deep P-well in combination with a thin 4 micron epi layer (sample 64067-2) results in much lower blooming.

Specifically, for samples 64066-2 and 64067-2, in addition to the standard, shallow 1.5E13 B11 P-well implant at 180 keV, there are additional deep P-well implants at higher implant energies to improve blooming and cross-talk. The specific parameters of each sample are summarized in Table 1. Note that all doses quoted herein are in units of ions/cm². Samples 64066-5 and 64066-2 are both formed on 8 micron epi and sample 64067 uses a 4 micron epi.

**Table I**

| **Sample Number** | **Epitaxial Layer Thickness** | **Deep P-well Implants** |
|---|---|---|
| 64066-5 | 8 microns | None |
| 64066-2 | 8 microns | 3E12 B11 420 keV + 1E13 B11 800 keV + 1E13 B11 1.3 MeV |
| 64067-2 | 4 microns | 3E12 B11 420 keV + 1E13 B11 800 keV + 1E13 B11 1.3 MeV |

The data points corresponding to 64066-5 shows the blooming performance for the case of an image sensor made from a thick 8 micron epi and a shallow P-well (SPW) using a 1.5E13 B11 implant at 180 keV. In this case, the bright image blooms 14 pixels (44 u) laterally into the dark region. On sample 64066-2 a DPW has been added to the 8u epi. The DPW is formed by adding the following 3 implants: 3E12 B11 at 420 keV + 1E13 B11 at 800 keV + 1E13 B11 at 1.3 MeV. The result is only a slight reduction in blooming from 14 pixels to 12 pixels in the negative Vtx_lo region.

However, in sample 64067-2 the same 3 DPW implants have been combined with the 4 u epi and there has been a substantial reduction in blooming down to 4 pixels. As can be seen in Figure 3, with the TG fully on near 0 volts, there is still blooming of 3 pixels. This 3 pixel residual blooming is believed to be the result of optical blooming. So with the new process and structure of combining a DPW plus the shallow epi, the electrical component of the blooming has been reduced to I pixel. Thus, both a shallow epi thinner than 8u and DPW implants are required to achieve substantially improved electrical blooming performance.

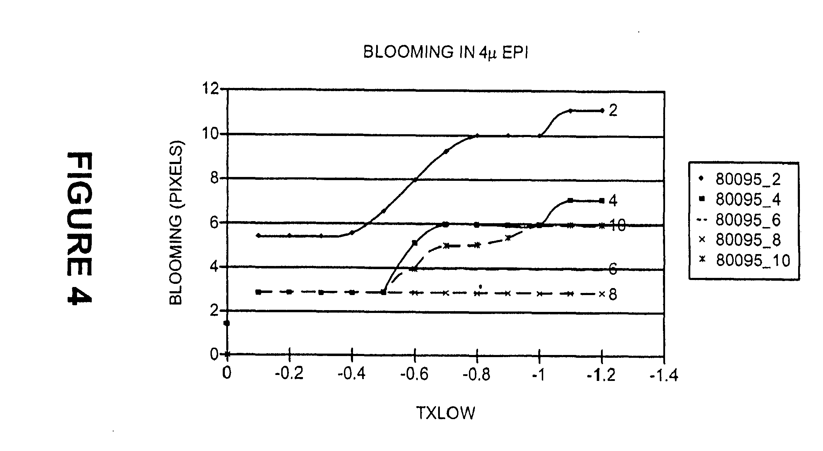

Figure 4 shows a more careful study on the reduction of blooming as a function of the DPW implant conditions, all using a 4 micron epi. In addition to the standard PWell implant at 180 keV there are additional deep P-well implants to improve blooming and cross-talk as summarized in Table 2 below.

**Table II**

| **Sample Number** | **P-well Implant** | **Deep P-well Implants** |
|---|---|---|
| 80095-2 | 2E13 B11 180 keV | None |
| 80095-4 | 2E13 B11 180 keV | 3E12 B11 420 keV |
| 80095-6 | 2E13 B11 180 keV | 3E12 B11 420 keV + 1E13 B11 700 keV |
| 80095-8 | 2E13 B11 180 keV | 3E12 B11 420 keV + 1E13 B11 700 keV + 1E13 B11 1.3 MeV |
| 80095-10 | 2E13 B11 180 keV | 3E12 B11 420 keV + 1E12 B11 700 keV |

The reference sample in Figure 4 is 80095-2 which is a single standard 2E13 B11 shallow P-well at 180 keV. In the case of sample 80095-2 the total measured blooming is 11 pixels at Vtx_lo = -1.2 volts. What is clear here is that even with the thin 4u epi, blooming remains unacceptable. Thus, the use of a thin epi layer has a minor effect. Sample 80095-4 has a 3E12 B11 420 keV implant added and the lateral extent of the blooming is decreased. Sample 80095-10 then adds a 700 keV B11 implant but only at a 1E12 dose. This does not further significantly improve the blooming. But when the implant dose of the 700 keV implant is increased to 1E13 on sample 80095-6, the electrical component of the blooming is reduced to 1 pixel (total blooming of 4 with an optical component of 3 and an electrical component of 1). Further, if a B11 implant of 1E13 is then added at 1.3 MeV, then the electrical component to blooming is completely eliminated. The data in Figures 3 and 4 show that both a thin epi and a deep P-well implant are required to effectively eliminate blooming. By themselves they are not nearly as effective. It is only when combined into an optimized process that this effect is seen.

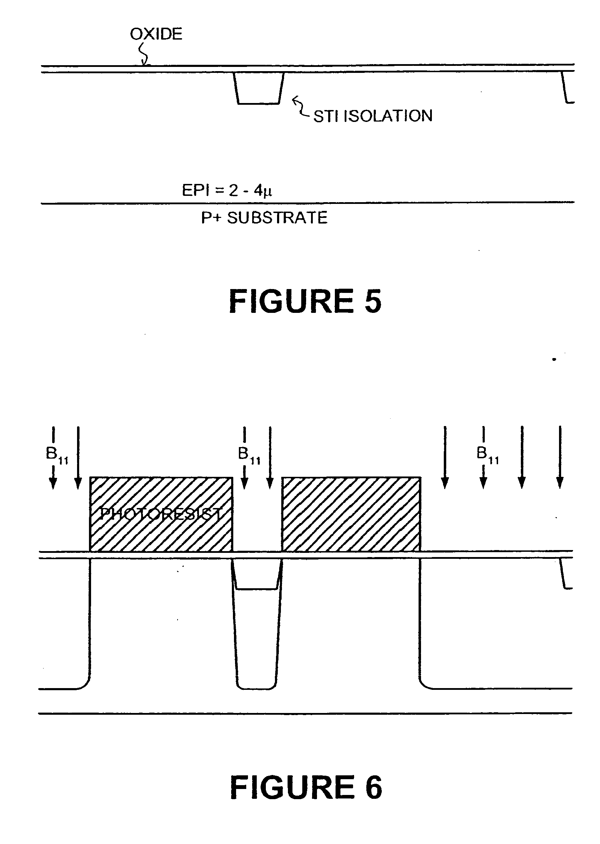

Figures 5 and 6 describe a method for forming a pixel in accordance with one embodiment of the present invention. As seen in Figure 5, an epitaxial material is deposited onto a p-type substrate. In this embodiment, the thickness of the epi is generally between 3 and 5 microns thick, but may be up to 6 microns thick as noted above. It has been found that an epi thickness of between 3 and 4.5 microns works well. Active areas and STI oxide isolation is formed as is conventional in the art. A thin oxide, typically termed a pad oxide or a sacrificial oxide or a gate oxide is formed over the epi layer.

A thick deep ultraviolet (DUV) or 1-line resist of sufficient thickness to block the highest energy P-well implant is then coated onto the wafer. The photoresist is patterned as shown in Fig 6. The photosensitive element regions have thick resist remaining over those regions. Between the photosensitive elements and in the associated pixel transistors (transfer gate, reset gate, source follower gate, row select gate) the photoresist is removed. A series of deep P-well implants is performed to achieve the optimized blooming and cross-talk performance. In general, the deep P-well implants should contain at least one implant that is equal to or greater than 700 keV. This provides a deep p-well depth of about 1.2 microns. The 1.3 MeV implant will generally produce a deep p-well depth of about 1.9 microns. The implant dose should also be equal to or greater than 3E12 ions/cm2.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof, means any connection or coupling, either direct or indirect, between two or more elements; the coupling of connection between the elements can be physical, logical, or a combination thereof.

Additionally, the words "herein," "above," "below," and words of similar import, when used in this application, shall refer to this application as a whole and not to any particular portions of this application. Where the context permits, words in the above Detailed Description using the singular or plural number may also include the plural or singular number respectively. The word "or," in reference to a list of two or more items, covers all of the following interpretations of the word: any of the items in the list, all of the items in the list, and any combination of the items in the list.

The above detailed description of embodiments of the invention is not intended to be exhaustive or to limit the invention to the precise form disclosed above. While specific embodiments of, and examples for, the invention are described above for illustrative purposes, various equivalent modifications are possible within the scope of the invention, as those skilled in the relevant art will recognize.

The teachings of the invention provided herein can be applied to other systems, not necessarily the system described above. The elements and acts of the various embodiments described above can be combined to provide further embodiments.

Changes can be made to the invention in light of the above Detailed Description. While the above description describes certain embodiments of the invention, and describes the best mode contemplated, no matter how detailed the above appears in text, the invention can be practiced in many ways. Details of the compensation system described above may vary considerably in its implementation details, while still being encompassed by the invention disclosed herein.

As noted above, particular terminology used when describing certain features or aspects of the invention should not be taken to imply that the terminology is being redefined herein to be restricted to any specific characteristics, features, or aspects of the invention with which that terminology is associated. In general, the terms used in the following claims should not be construed to limit the invention to the specific embodiments disclosed in the specification, unless the above Detailed Description section explicitly defines such terms. Accordingly, the actual scope of the invention encompasses not only the disclosed embodiments, but also all equivalent ways of practicing or implementing the invention under the claims.

While certain aspects of the invention are presented below in certain claim forms, the inventors contemplate the various aspects of the invention in any number of claim forms. Accordingly, the inventors reserve the right to add additional claims after filing the application to pursue such additional claim forms for other aspects of the invention.

## Claims

1. A pixel array comprising:
a plurality of pixels arranged in a pattern and formed on an semiconductor substrate with a thin epitaxial layer less than 5 microns in depth;
isolation structures formed in said semiconductor substrate, said isolation structures separating adjacent pixels of at least a portion of said plurality of pixels, said isolation structures including at least a deep p-well extending greater than about 1.2 microns into said epitaxial layer.

2. The pixel array of Claim 1 wherein said isolation structures also include a shallow trench isolation.

3. The pixel array of Claim 1 wherein said P-well is formed from an implant energy of greater than 700 keV.

4. The pixel array of Claim 3 wherein the dosage of said P-well is at least 1e13 ions/cm².

5. The pixel array of Claim 3 wherein the dosage of said P-well is at least 3e12 ions/cm².

6. The pixel array of Claim 1 wherein said plurality of pixels are 3T, 4T, 5T, 6T, or 7T pixels.

7. The pixel array of Claim 1 wherein said P-well is formed from a dual implant: a first implant at greater than 700 keV and a second implant of about 1.3 MeV.

8. A pixel array comprising:
a plurality of pixels arranged in a pattern and formed on an semiconductor substrate with a thin epitaxial layer less than 6 microns in depth;
isolation structures formed in said semiconductor substrate, said isolation structures separating adjacent pixels of at least a portion of said plurality of pixels, said isolation structures including at least a deep p-well formed using an implant energy of at least 700 keV and with a dosage of at least 3e12 ions/cm².

9. The pixel array of Claim 8 wherein said epitaxial layer is between 3 and 4.5 microns thick.

10. The pixel array of Claim 8 wherein said isolation structures also include a shallow trench isolation.

11. The pixel array of Claim 8 wherein said P-well has a depth of at least 1.2 microns into the epitaxial layer.

12. The pixel array of Claim 8 wherein the dosage of said P-well is at least 1e13 ions/cm².

13. The pixel array of Claim 8 wherein said plurality of pixels are 3T, 4T, 5T, 6T, or 7T pixels.

14. The pixel array of Claim 9 wherein said P-well is formed from a dual implant: a first implant at greater than 700 keV and a second implant of about 1.3 MeV.

15. A pixel array comprising:
a semiconductor substrate;
an epitaxial layer formed on said semiconductor substrate having a thickness of less than 5 microns;
a plurality of pixels arranged in a pattern and formed on said epitaxial layer;
isolation structures formed in said semiconductor substrate, said isolation structures separating adjacent pixels of at least a portion of said plurality of pixels, said isolation structures including at least a deep p-well formed using an implant energy of at least 700 keV and with a dosage of at least 3e12 ions/cm².

16. The pixel array of Claim 15 wherein said pixel array is part of a CCD image sensor.

17. A method for forming an isolation structure using in a pixel array, said pixel array including a plurality of pixels arranged in a pattern and formed on an semiconductor substrate with a thin epitaxial layer less than 6 microns in depth, said isolation structure separating adjacent pixels of at least a portion of said plurality of pixels, the method comprising:
forming a deep P-well in said epitaxial layer by implanting a p-type dopant using at least 700 keV and to a dopant concentration of at least 3e12 ions/cm².

18. The method of Claim 17 wherein the dosage of implant for said P-well is at least 1e13 ions/cm².

19. The method of Claim 17 wherein said P-well is formed from a dual implant: a first implant at greater than 700 keV and a second implant of about 1.3 MeV.
